# EUROPEAN PATENT APPLICATION

(11) **EP 0 668 634 A2**
(43) Date of publication of application: **23.08.1995**
(21) Application number: 94309439.1
(22) Date of filing: 16.12.1994
(51) Int. Cl.: H01R 23/02

(54) **High performance electrical connector**

(30) Priority: 21.01.1994 US 184129; 17.06.1994 US 262080
(71) Applicant: THE WHITAKER CORPORATION, Wilmington, Delaware 19808 (US)
(72) Inventor: Ferry, Julian J., Kernersville, North Carolina 27284 (US)
(74) Representative: Warren, Keith Stanley

(57) **Abstract**

A system is provided for reducing crosstalk in an electrical connector, where the typical connector (10) is a multi-contact electrical connector comprising a pair of intermatable connector members (12,14). Each connector member (12,14) is adapted to be terminated to plural conductors (16) A typical connector comprises a housing (12) formed of an insulative material having a conductor receiving side (22), a mating side (24), and a plurality of contact receiving cavities (2) extending from the conductor receiving side (22) to said mating side (24). The cavities (20) are arranged in rows on a spaced-apart parallel axes, where adjacent rows are separated by an insulative housing wall (30). An array of electrical contact terminals (42) is provided in the cavities (20), where each of the contact terminals (42) has a contact means at its forward end proximate to the mating side (24) and conductor terminating means (36) proximate to the conductor receiving side (22). An electronic device (13) having discrete electrical circuit traces (68) along the surfaces thereof, is disposed in close proximity to the array of contact terminals (42), but not in ohmic contact therewith, to improve connector performance by coupling energy between certain conductors.

## Description

This invention is directed to a high performance electrical connector which reduces crosstalk and yields improved signal transmission qualities that meet or exceed Category 5 requirements for connector hardware by the use of capacitive coupling to affect connector balance. Crosstalk reduction is achieved by using energy which is capacitively coupled through the use of an insert that is located in close proximity to the connector terminals, where such insert includes discrete conductive traces that are in non-ohmic contact with said terminals.

Crosstalk may be simply defined as that situation when two signal carrying circuits extend close together where the existence of signaling currents in one circuit will tend to set up corresponding currents in the other. With the present trend for increasing transmission rates of electrical connecting devices, there followed the increasing demand for improved performance, particularly in the reduction of crosstalk at frequencies up to 100 MHz. As a consequence of this demand, the Telecommunications Industry Association (TIA) in cooperation with the Electronic Industries Association (EIA) recently developed a proposed standard for Category 5 components, where the transmission requirements of such components are characterized up to 100 MHz and are typically intended for emerging applications with transmission rates up to 100 Mbps. The standard is preliminarily identified as TSB40, August 1992. The invention hereof relates to the hardware, but it is important to note that the hardware is only one major element of a communication system, while another major component is the transmission cable. Thus, it is important to insure the use of the correct connecting component or hardware that is compatible with the transmission characteristics of the cable. Such cables are typically high performance unshielded twisted-pair (UTP) cables, the performance characteristics of which are covered by EIA/TIA bulletin TSB-36.

Returning now to the component aspect of a transmission system, one of the more important test parameters for high performance electrical connector hardware, i.e. Category 5, is Near-End Cross-Talk (NEXT) Loss. This may be further defined as a measure of signal coupling from one circuit to another within a connector and is derived from swept frequency voltage measurements on short lengths of 100-ohm twisted-pair test leads terminated to the connector under test. A balanced input signal is applied to a disturbing pair of the connector while the induced signal on the disturbed pair is measured at the near-end of the test leads. In other words, NEXT loss is the way describing the effects of signal coupling causing portions of the signal on one pair to appear on another pair as unwanted noise. In any case, the worst case NEXT loss, see values below in TABLE I, for any combination of disturbing and disturbed pairs is determined by the formula:
NEXT (F) NEXT (16) - 20 Log (F/16) where NEXT (16) is the minimum NEXT loss at 16 MHZ, F is frequency (in MHZ) in the range from 1 MHZ to the highest referenced frequency, and NEXT (F) is the performance at that frequency.

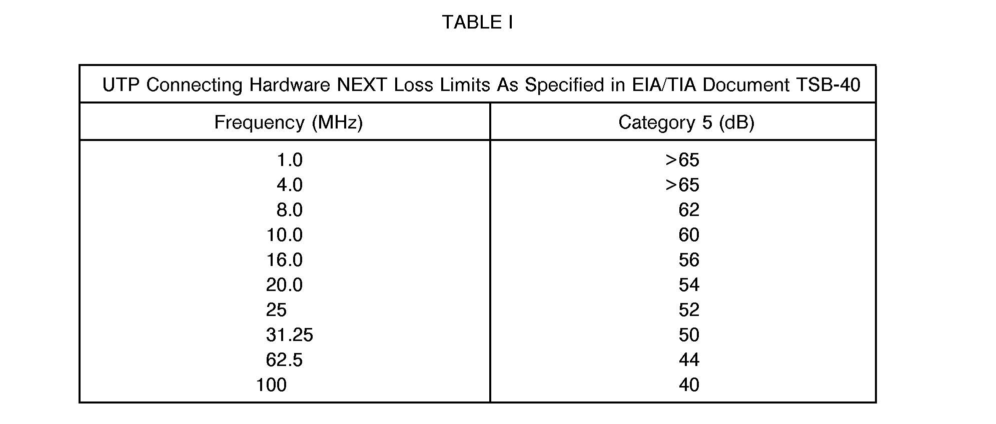

While problems associated with crosstalk have been known for years, as evidenced by U.S. Patent Nos. 1,995,454 and 2,080,217, a major concern has only recently come to the forefront by the current demands for improved performance and higher signal transmission qualities. A recent development is represented by U.S. Patent No. 5,186,647 to Denkmann et al. A major objective of the patent is to reduce crosstalk between specific conductors in a connector. A preferred embodiment thereof is a panel mount modular jack which includes a pair of lead frames, each comprising four, flat elongated conductors. The lead frames are mounted on top of each other and their conductors are all generally parallel and close to each other throughout a portion of the length of the conductors. The claimed improvement in crosstalk performance is achieved by a selected crossover pattern of the conductors without electrical contact being made because of a reentrant bend in the conductors in the crossover region.

The present invention achieves Category 5 performance by a significant reduction in crosstalk with capacitive coupling through non-ohmic contact. Such performance, and the manner by which it is achieved, will become apparent in the description which follows, particularly when read in conjunction with the accompanying drawings.

A first embodiment of the invention hereof relates to a high performance electrical connector which reduces crosstalk and yields improved signal transmission qualities that meet or exceed Category 5 requirements. An unmodified connector of the type contemplated by this invention is disclosed in U.S. Patent No. 3,760,335. Such connector comprises a pair of intermatable connector members, where each of the connector members is adapted to be terminated to plural conductors. Each connector member comprises a housing formed of an insulative material with a conductor receiving side and mating side, and a plurality of contact receiving cavities extending from the conductor receiving side to the mating side. The cavities are arranged in rows on spaced-apart parallel axes, where adjacent rows are separated by an insulative housing wall. An array of electrical contact terminals are disposed within the cavities, where each of the contact terminals includes contact means at its forward end proximate to the mating side, and conductor terminating means proximate to the conductor receiving side. The improved feature of this invention is the provision of the insulative housing wall intermediate the array of terminals including an elongated cavity essentially coextensive with the array of contact terminals. Disposed within the elongated cavity is a planar electronic device having discrete electrical circuit traces along the planar surfaces thereof. By the arrangement and alignment of such traces, improved performance through capacitive coupling of energy between certain pairs of conductors is achieved.

The second embodiment according to this invention utilizes a flexible film, having a pattern of discrete electrical circuit traces along a first surface thereof, where the flexible film is placed directly under the contact terminals, and the film contact surface is the opposite surface free of such traces. By this arrangement, there is no ohmic, i.e. metal-to-metal, contact between the contact terminals and traces on the film, whereby energy is capacitively coupled from one or a pair of terminals to a second or different pair of terminals in a manner that reduces differential mode crosstalk.

Embodiments of the present invention will now be described by way of example with reference to the accompanying drawings in which:
FIGURE 1 is a perspective view of an electrical connector housing which utilizes capacitive coupling through non-ohmic contact for improved connector performance, and an insert according to a first embodiment of this invention, exploded therefrom;
FIGURE 2 is a longitudinal sectional view of a pair of intermatable connector housing members modified by the embodiment of Figure 1 to meet or exceed Category 5 requirements, as hereinafter explained;
FIGURES 3 to 5 are plan views illustrating alternate trace patterns for electronic coupling devices, or the inserts, such as illustrated in Figures 1 and 2, for coupling energy from one or a pair of conductors, to a second or pair of conductors, through non-ohmic contact;
FIGURE 6 is a perspective view of an electrical connector housing with contact terminals which utilize capacitive coupling through non-ohmic contact by the teachings of a second embodiment of this invention, where thin inserts exploded therefrom, such as flexible film, having a pattern of discrete electrical traces along a first surface thereof, placed directly under the contact terminals, as indicated by the direction arrows;
FIGURE 7 is a longitudinal sectional view of a pair of intermatable connector housing members, similar to Figure 2, but modified by the insert of the second embodiment hereof to meet or exceed Category 5 requirements;
FIGURE 8 is a perspective view of an electrical connector housing with contact terminals, similar to Figure 6, where the improved performance is achieved by the use of a single flexible film insert placed in non-ohmic contact with the terminals;
FIGURE 9 is a longitudinal sectional view of a single connector housing member taken transversely of the connector of Figure 8;
FIGURES 10-12 are plan views of the thin capacitive inserts for use in the embodiment of Figures 6 and 7, where Figure 12 shows one insert overlying a second insert as used in the embodiment of Figure 6; and
FIGURE 13 is a plan view of a single flexible film insert, prior to folding into U configured manner, for use in the embodiment of Figure 8 and 9.

This invention is directed to an electrical connector which utilizes an electronic device, preferably a planar device, such as a printed circuit board (PCB), or a flexible film, having a multiplicity of discrete circuit traces along the surfaces thereof, where such device is interposed between and in non-contact relationship to plural arrays of electrical contacts within such connector, to achieve the enhanced performance needed to exceed Category 5 requirements.

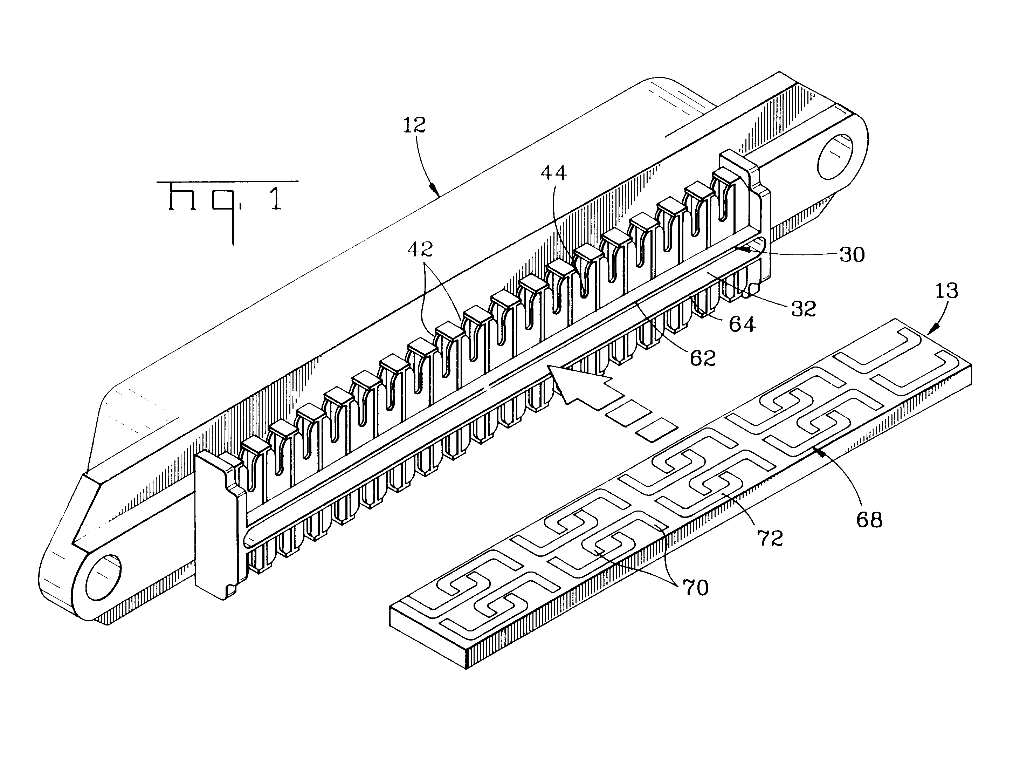

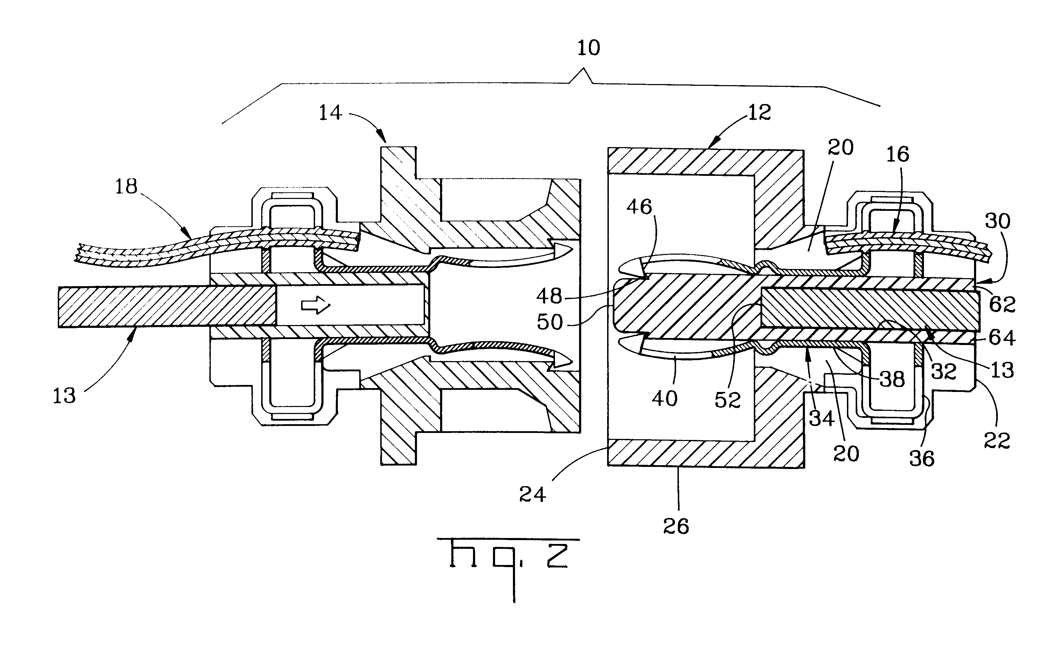

Figures 1 and 2 represent a typical multi-contact electrical connector 10 which utilizes a specially designed electronic device 13 to achieve the high performance desired.

Referring now in more detail to the Figures, a multi-contact electrical connector in accordance with a preferred embodiment of this invention is disclosed. The connector 10 typically comprises a pair of intermatable connector members 12, 14 such as a plug and receptacle, as known in the art. As will be apparent from the description below, both of these connector members contain a plurality of contact terminals which are electrically and mechanically connected to individual conductors or wires contained in cables 16, 18. When the connector members 12, 14 are coupled to each other the conductors in the cables will then be connected to each other. Though only one connector member will be described in detail, it should be understood that the complementary connector member operates in a similar manner.

The connector housing member 12, illustrated in the Figures, but without the cable 16 in Figure 1, comprises a dielectric housing of a suitable plastic, having plural arrays of cavities 20 extending from a conductor receiving side 22 to a connector mating side 24. The mating side 24, for the connector housing member 12, includes an encircling shroud 26 for matably receiving therein connector housing member 14.

The embodiment of the Figures illustrates the connector 10 as having a plurality of cavities 20 arranged in two parallel rows and are identical to each other, although the cavities of the lower row are inverted relative to the cavities of the upper row. Between such parallel rows of cavities, a dielectric wall 30 is provided, where such wall preferably includes a continuous, elongated slot 32 coextensive in width to the respective rows of cavities. The purpose for such slot will become apparent in the further description later.

Each cavity 20 contains a pre-loaded electrical contact terminal 34 comprising a rearward conductor connecting section 36, a shank portion 38, and a contact portion 40. The conductor connecting section 36 is generally U-shaped and has an opening 42 extending into the bight of the U. This opening communicates with slots 44 in each leg of the U which have a width somewhat less than the diameter of the conducting core of the conductor to which the terminal is to be connected. As known in the art, the manner of terminating the various conductors of cable 16 to the contact terminal 34, particularly the conductor connecting portion 36, is insulation displacement, or IDC. In the embodiment of Figure 2, the contact portion 40 is illustrated as bowed terminating in a latching barb 46 which is adapted to engage a complementary shoulder 48 at the mating end 50 of dielectric wall 30. By this arrangement, the contact terminals are fixed within the housing member, particularly during mating with the complementary housing member 14.

Turning now to the improved feature according to this invention, it will be recalled that in a preferred embodiment an elongated slot 32 has been provided within the dielectric wall 30. According to prior art practices and construction, such wall typically was formed with plural space-apart vertically oriented ribs. However, by this new design, the slot 32 is continuous to lie between and laterally extensive with the two rows of contact terminals 34. The depth 52 thereof is sufficient to cover at least the shank portion 38 of the terminal contact. In a preferred embodiment, for the connector of this invention, the overall wall height is about 0.135 inches, a slot height of about 0.095 inches, leaving a thin wall 62, 64 above and below, of a thickness of about 0.020 inches each. By this arrangement, such slot can readily receive a PCB that is about 0.093 inches in thickness. While a thin wall is preferred, its ultimate thickness will depend considerably on the molding material and molding technique.

To achieve the improved performance according to this invention, as best seen in Figure 1, an electronic device 12, such as a PCB, is provided for insertion into slot 32. The PCB, along each major surface thereof, is provided with a plurality of discrete traces or paths 68, where such paths are a series of staggered, interfitting "U's". Each path 68 includes a pair of axially arranged arms 70 joined together by a lateral arm 72. The respective arms 70 of a given path 68 are positioned to underlie, or overlie as the case may be, alternate contact terminals 34. In operation, though the paths 68 are electrically insulated from the contact terminals 34 by virtue of the thin walls 62 or 64, i.e. non-ohmic contact, the discrete paths 68 are positioned to receive an induced EMF from the respective contact terminals 34.

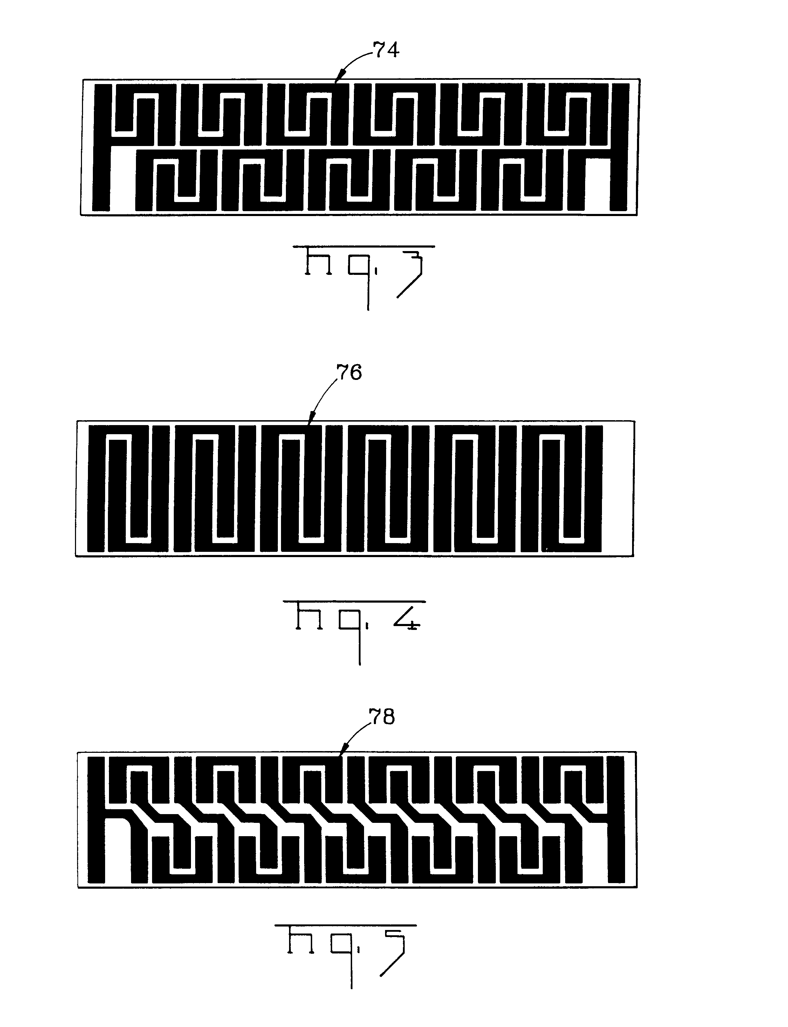

Figures 3-5 are plan views of three different trace patterns for the inserts or coupling devices 74, 76, 78. While the preferred manner for developing said patterns is by etching and plating, as known in the art, there are other techniques. That is, the coupling device may be something other than an etched and plated trace on a PCB. A good definition of said device is that it must include a conductive material with a dielectric material situated between the conductive material and the signal-carrying conductors of the connector between which additional coupling is desired. Other forms could be a stamped metal array, specially shaped wires, or additional traces on an existing PCB. The existing PCB could be a computer motherboard, for example, or a board used in other connecting devices. It is important to note that this technique differs from other approaches of the prior art, in that an additional trace is a branch from a signal-carrying trace. In the present invention the trace would not be a part of an existing signal carrying trace, i.e., it would not be ohmically connected.

From the several Figures illustrating exemplary coupling devices, inserts, or PCBs, the traces are generally discrete traces. The traces are positioned so that energy is coupled from one conductor of a pair to one conductor of a second pair in a manner that compensates for imbalances in coupling that are inherent in the existing connector.

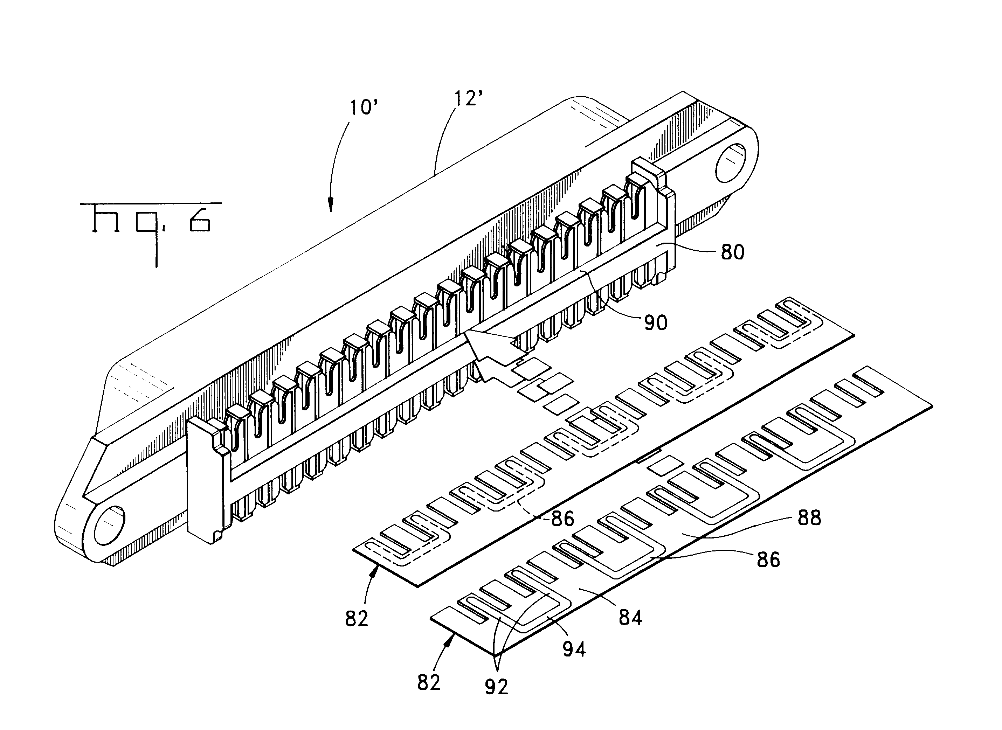

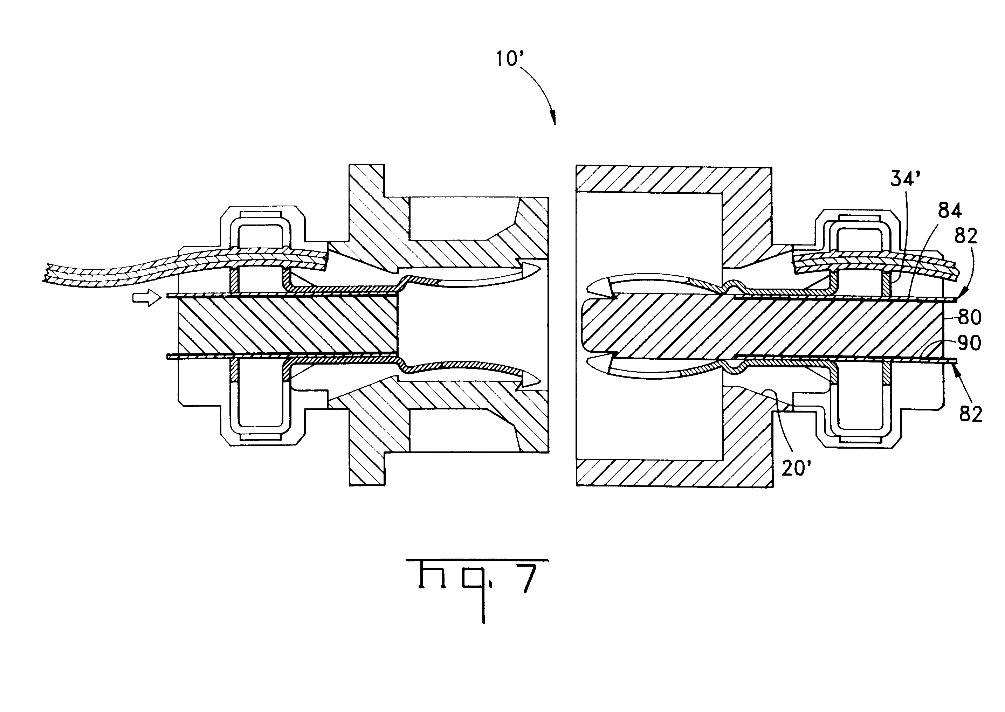

In any case, the capacitive coupling, as illustrated in Figure 2, may be carried out in the plug, the receptacle, or both. The pattern can be chosen so that energy is coupled from both conductors of one pair to both conductors of a second pair, as illustrated in Figures 3 and 5, or by coupling from only one conductor of a pair to one conductor of a second pair, as shown in Figure 4, or any combination of these two techniques. The first technique represents the preferred approach as better balance can be achieved.

The improved performance of the connector of this invention may best be demonstrated by comparing a prior art connector utilizing the ribbed intermediate wall, i.e. no PCB, with a connector having a PCB disposed within a slot provided in the intermediate wall. The respective connectors are identified as Prior Art and Invention, with the results thereof presented in the TABLE. The data is power sum data from nine pairs adjacent to a single monitored pair. This data was obtained by measuring the crosstalk from each one the nine pairs closest to the monitored pair individually, and then mathematically adding the crosstalk together to obtain one overall number.

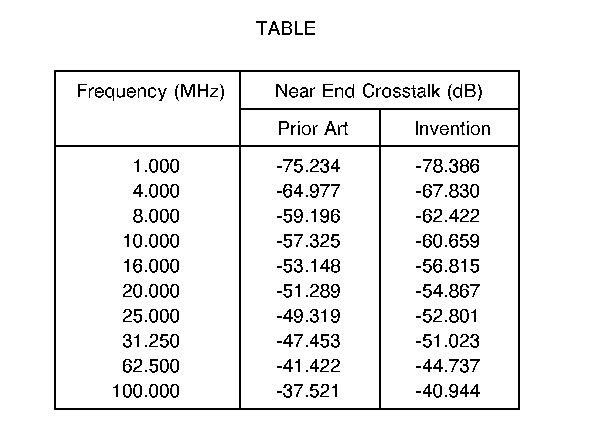

Note that the data is presented as negative numbers. Thus, the higher the number, the better the performance at the designated frequency. It will be recalled from the initial discussion on the performance requirements of Category 5 products that a value of at "40" at 100 MHz was required. By the inclusion of the specially designed electronic device into the connector of the prior art, the improved performance thereof exceeded Category 5 requirements, particularly at the critical frequency of 100 MHz.

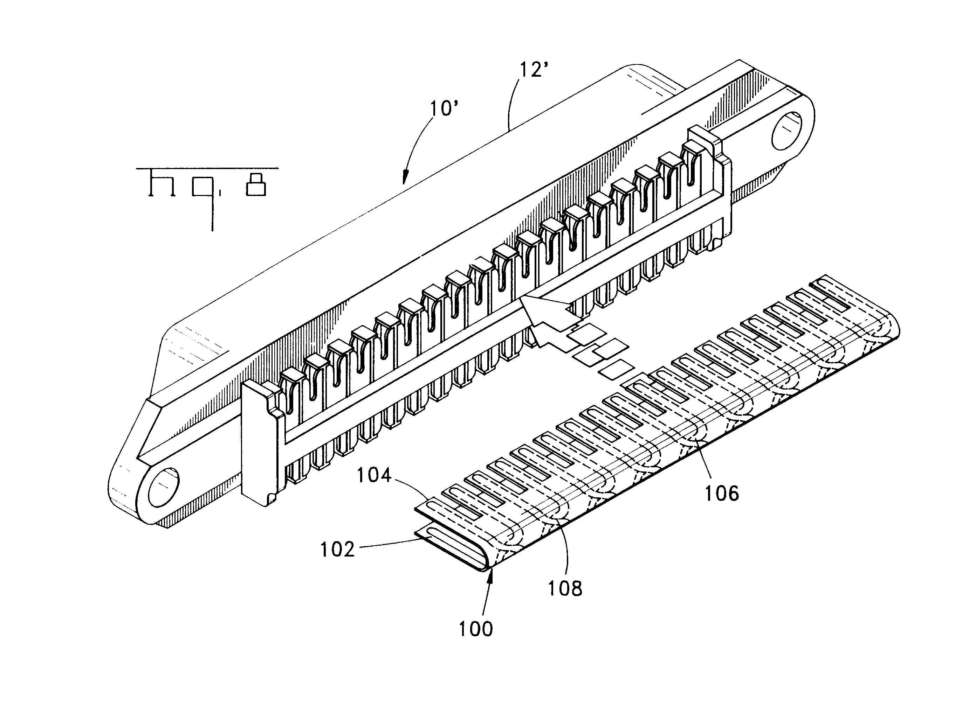

A second preferred embodiment of this invention is illustrated in Figures 6 to 13, where such embodiment preferably uses a flexible film having a multiplicity of discrete circuit traces along a surface thereof, where the film is placed adjacent to the plural arrays of electrical contacts within the connector. The traces are on a film surface not in contact with the electrical contacts i.e. isolated by the film body from the contacts, to achieve the enhanced performance needed to exceed Category 5 requirements.

A typical multi-contact electrical connector 10' suitable for practicing this invention is illustrated in Figures 6 to 9, with the obvious difference from the first embodiment being the omission of the housing slot to receive the planar insert as described. Accordingly, reference to the connector housing and contacts may be found above.

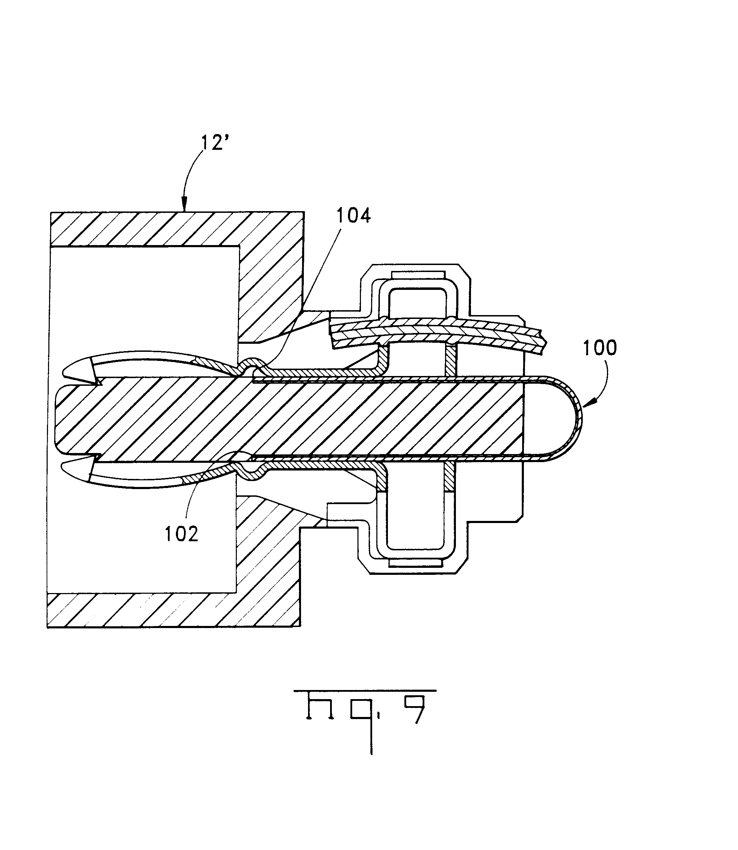

Turning to the unique features of the second embodiment, disposed between the dielectric wall 80, and the arrays of contact terminals, are a pair of electronic devices 82 in the form of a thin flexible film 84 having discrete traces 86 of electrical circuitry along a surface 88 that lies adjacent to the wall 90 of dielectric wall 80, see Figure 7, where the preferred system includes a continuous film portion having plural fingers extending laterally therefrom along one or both of the major edges. By this arrangement, the discrete traces are in close proximity to the contact terminals, but not in ohmic contact therewith. As illustrated in the embodiment of Figures 7 and 10-12, the discrete traces 86 are a series of adjacent "U's" extending from one said finger to another. Each trace includes a pair of axially arranged arms 92 joined together by a lateral arm 94. The respective arms 92 of a given trace 86 are positioned to underlie alternate contact terminals 34'. In operation, though the traces 86 are electrically insulated from the contact terminals 34' by virtue of the film body, i.e. non-ohmic contact, the discrete traces 86 are positioned to receive an induced EMF from the respective contact terminals 34'.

A type of flexible film contemplated by this invention may comprise a thin flexible polyamide film on which the traces are formed, such as etched copper traces. A suitable film thickness for practicing this invention is on the order of about 10 to 12 mils. However, there are other known procedures for forming such traces on the flexible film.

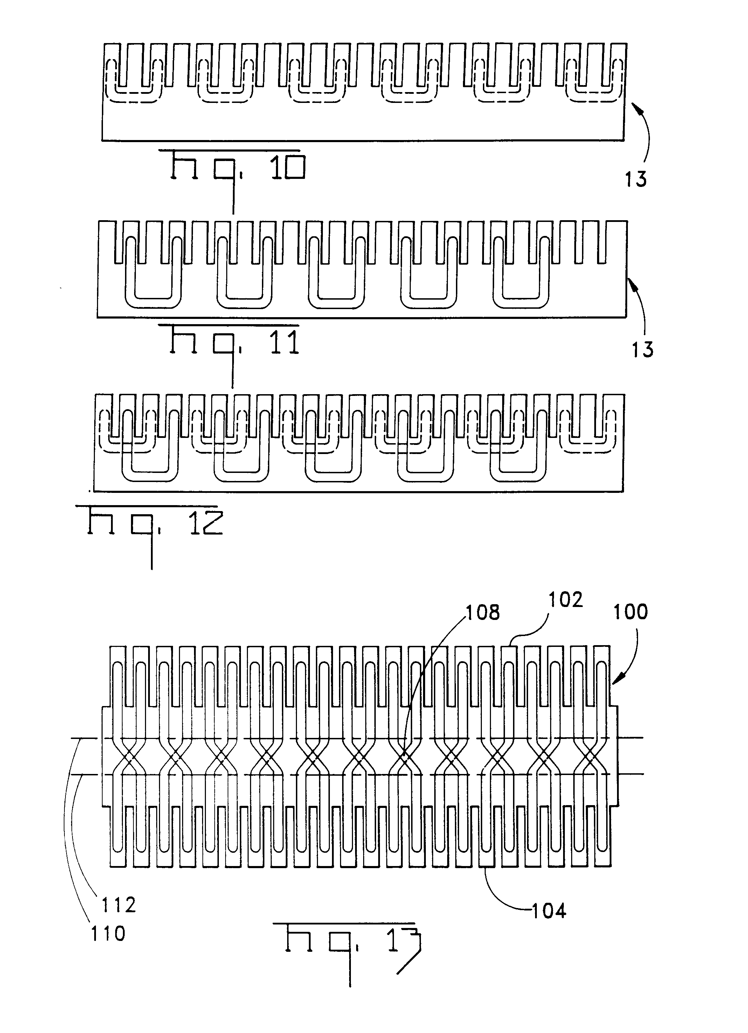

Figures 8 and 9 represent an alternate embodiment where a single electronic device 100, in the form of a single U-configured flexible film has its respective ends 102,104 disposed within the cavities 20' adjacent the contact terminals 34'. As best seen in Figure 8, the traces 106 extend from end 102 to end 104, with a non-contact crossover 108. By this arrangement an upper contact terminal, for example, is non-ohmically coupled to a lower contact terminal.

Whether one selects the single electronic device of Figures 8, 9, and 13, or the plural devices of Figures 6, 7, and 10-12, a common feature thereof is the imposition of a conductive material on a dielectric material, situated where the dielectric material is between the conductive material and the signal-carrying conductors of the connector between which additional coupling is desired. In any case, it is important to note that this technique differs from other approaches of the prior art in which an additional trace is a branch from a signal-carrying trace. In the present invention the trace would not be a part of an existing signal carrying trace, i.e., it would not be ohmically connected.

As best illustrated by the plan views of Figures 10-13, the traces are generally discrete traces. The traces are positioned so that energy is coupled from one conductor of a pair to one conductor of a second pair in a manner that compensates for imbalances in coupling that are inherent in the existing connector. For either embodiment, the method of compensation may either through better balancing of the coupled signals, or through intentional unbalancing as described in U.S. Patent No. 5,341,419, granted 23 August 1994 to the inventor hereof, the description of which is incorporated herein by reference.

In any case, the capacitive coupling, as illustrated in Figures 7 and 9, may be carried out in the plug, the receptacle, or both. The trace pattern on the electronic device 82,100 can be chosen so that energy is coupled from a single conductor of a pair to a single conductor of a second pair within an array, or coupled between two conductors in different arrays of contact terminals. Figure 13 illustrates a planar electronic device 100, which when folded along the lines 110,112 can be inserted into the connector 12' to couple one conductor from the upper array of terminals to the lower array.

## Claims

1. A multi-contact electrical connector (10,10') comprising a pair of intermatable connector members (12,12',14,14') where each said connector member is adapted to be terminated to plural conductors, and comprises a housing (12) formed of an insulative material and having a conductor receiving side (22) and a mating side (24), a plurality of contact receiving cavities (20) extending from said conductor receiving side (22) to said mating side (24), said cavities (20) being arranged in rows on spaced-apart parallel axes, where adjacent rows are separated by an insulative housing wall (30,80), and an array of electrical contact terminals (42) in said cavities, each of said contact terminals (42) having contact means at its forward end proximate to said mating side (24) and conductor terminating means (36) proximate to said conductor receiving side (22), characterized by the provision of an electronic device (13,82,100) having discrete electrical circuit traces (70,86) along the surfaces thereof, where said device is disposed in close proximity to said array of contact terminals (42),and said traces (70,86) are in non-ohmic contact with said contact terminals (42), whereby to improve connector performance, through capacitive coupling of energy between certain pairs of conductors.

2. The multi-contact electrical connector (10,10') according to claim 1, characterized in that said insulative housing wall (30) includes an elongated slot (32), and that said electronic device (13) is a planar member receivable in said slot.

3. The multi-contact electrical connector according to claim 2, characterized in that said electrical circuit traces (70) are separated from said contact terminals by a thin insulative wall (64), whereby the capacitive coupling is through non-ohmic contact and said improved connector performance is a reduction in crosstalk between respective conductors of terminated electrical contacts.

4. The multi-contact electrical connector according to claim 2, characterized in that said electronic device (13) is a printed circuit board having a preselected pattern of discrete conductive traces along the major surfaces thereof.

5. The improved multi-contact electrical connector according to claim 4, characterized in that said traces (70) are transversely patterned along two rows on said surfaces.

6. The multi-contact electrical connector according to claim 1, characterized in that the electronic device (82) is inserted between said insulative housing wall (90) and said contact terminals (42), where said electronic device is a thin dielectric film having plural discrete electrically conductive traces (86) along a surface thereof.

7. The electrical connector according to claim 6, characterized in that there are two rows of cavities separated by a common insulative housing wall (80), and that said electronic device is a single film whose respective ends are inserted between the respective contact terminals and said common insulative housing wall (80).

8. The electrical connector according to claim 7, characterized in that said electronic device (100) includes a continuous central portion having plural fingers extending laterally from each side thereof, and that said discrete electrically conductive traces extend from a said finger along one side (104) to a said finger along the opposite side (102).

9. The electrical connector according to claim 8, characterized in that certain adjacent said traces crossover (106) in a non contact relationship in said central portion.

10. The electrical connector according to claim 8, characterized in that there are two rows of cavities separated by a common insulative housing wall (80), and that two electronic devices (82) are placed respectively between each array of contact terminals and said common insulative housing wall (80), and that the respective traces are vertically staggered between two electronic devices.
